(19) Europäisches Patentamt / European Patent Office / Office européen des brevets

(11) **EP 3 564 695 B1**

(12) # EUROPÄISCHE PATENTSCHRIFT

(45) Veröffentlichungstag und Bekanntmachung des Hinweises auf die Patenterteilung:
**25.06.2025   Patentblatt 2025/26**

(21) Anmeldenummer: **18170822.3**

(22) Anmeldetag: **04.05.2018**

(51) Internationale Patentklassifikation (IPC):
*G01R 33/561* *(2006.01)*

(52) Gemeinsame Patentklassifikation (CPC):
**G01R 33/5611**

(54) **VERFAHREN ZUR ERZEUGUNG EINES MAGNETRESONANZ-BILDDATENSATZES, COMPUTERPROGRAMMPRODUKT, DATENTRÄGER SOWIE MAGNETRESONANZANLAGE**

METHOD FOR CREATING A MAGNETIC RESONANCE IMAGE DATA SET, COMPUTER PROGRAM PRODUCT, DATA CARRIER AND MAGNETIC RESONANCE SYSTEM

PROCÉDÉ DE GÉNÉRATION D'UN ENSEMBLE DE DONNÉES IMAGE PAR RÉSONANCE MAGNÉTIQUE, PRODUIT-PROGRAMME INFORMATIQUE, SUPPORT DE DONNÉES AINSI QU'INSTALLATION DE RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**06.11.2019   Patentblatt 2019/45**

(73) Patentinhaber: **Siemens Healthineers AG**
**91301 Forchheim (DE)**

(72) Erfinder:
• **Kartäusch, Ralf**
  **91058 Erlangen (DE)**
• **Paul, Dominik**
  **91088 Bubenreuth (DE)**
• **Carinci, Flavio**
  **91052 Erlangen (DE)**

(74) Vertreter: **Siemens Healthineers**
**Patent Attorneys**
**Postfach 22 16 34**
**80506 München (DE)**

(56) Entgegenhaltungen:
**US-A1- 2016 146 915**

• **HUANG F, CHEN Y: "Self-adjusted regularization ratio for robust compressed sensing", PROCEEDINGS OF THE INTERNATIONAL SOCIETY FOR MAGNETIC RESONANCE IN MEDICINE, 18 April 2009 (2009-04-18), pages 4592, XP040611823**
• **JAN AELTERMAN ET AL: "Automatic High-Bandwidth Calibration and Reconstruction of Arbitrarily Sampled Parallel MRI", PLOS ONE, vol. 9, no. 6, 10 June 2014 (2014-06-10), pages e98937, XP055526936, DOI: 10.1371/ journal.pone.0098937**
• **KEDAR KHARE ET AL: "Accelerated MR imaging using compressed sensing with no free parameters : Accelerated MR Imaging using Compressive Sensing", MAGNETIC RESONANCE IN MEDICINE., vol. 68, no. 5, 20 January 2012 (2012-01-20), US, pages 1450 - 1457, XP055525216, ISSN: 0740-3194, DOI: 10.1002/mrm.24143**
• **OREN N JASPAN ET AL: "Compressed sensing MRI: a review of the clinical literature", BRITISH JOURNAL OF RADIOLOGY., vol. 88, no. 1056, 16 October 2015 (2015-10-16), GB, pages 20150487, XP055525198, ISSN: 0007-1285, DOI: 10.1259/ bjr.20150487**

- KIEREN GRANT HOLLINGSWORTH: "Reducing acquisition time in clinical MRI by data undersampling and compressed sensing reconstruction", PHYSICS IN MEDICINE AND BIOLOGY, INSTITUTE OF PHYSICS PUBLISHING, BRISTOL GB, vol. 60, no. 21, 8 October 2015 (2015-10-08), XP020290393, ISSN: 0031-9155, [retrieved on 20151008], DOI: 10.1088/0031-9155/60/21/R297

- LUSTIG M ET AL: "Sparse MRI: the application of compressed sensing for rapid MR imaging", MAGNETIC RESONANCE IN MEDIC, JOHN WILEY & SONS, INC, US, vol. 58, no. 6, 29 October 2007 (2007-10-29), pages 1182 - 1195, XP007907974, ISSN: 0740-3194, DOI: 10.1002/MRM.21391

## Beschreibung

Die Erfindung betrifft ein computerimplementiertes Verfahren zur Erzeugung eines Magnetresonanz-Bilddatensatzes.

Die Magnetresonanztomographie weist gegenüber anderen klinischen Bildgebungsmethoden den Vorteil auf, dass sie keinerlei Röntgenstrahlung verwendet und Weichteilgewebe abbilden kann.

Ein Nachteil bestand anfangs in vergleichsweise extrem langen Messzeiten von mehreren Minuten für ein einziges Bild. Als bildgebende Messsequenzen waren die Spinecho-Sequenz und die Gradientenecho-Sequenz im Einsatz.

Der erste Schritt zur Verkürzung der Messzeit bestand in der Optimierung und Abänderung der Messsequenzen. Zur Beschleunigung der Gradientenecho-Sequenz wurde bspw. der Flipwinkel des Anregungsimpulses verringert. Dadurch konnte auch die Repetitionszeit $T_R$ stark verkürzt werden, wodurch die Messzeit für ein Bild nur noch im Bereich von Sekunden lag. Diese Sequenz ist unter dem Akronym FLASH bekannt.

Die Spinecho-Sequenz wurde durch das wiederholte Anlegen des Refokussierungsimpulses und anschließendes Auslesen eines Echosignals beschleunigt. Diese Sequenz ist unter den Akronymen FSE, TSE oder auch RARE bekannt.

Einer weiteren Beschleunigung durch die Abänderung der Messsequenzen alleine sind Grenzen im Hinblick auf das Nyquist-Theorem gesetzt. Dieses besagt, dass die Kodierung in der Richtung einer darzustellenden Dimension folgende Bedingung erfüllen muss:

$$\Delta k \ < \ 2\pi/L.$$

Dabei ist $\Delta k$ der Abstand der Signale im k-Raum und L die Ausdehnung des Objektes in der darzustellenden Dimension.

Kehrt man die Gleichung um erhält man den abbildbaren Bereich, auch Field of View genannt:

$$FoV \ = \ 2\pi/ \ \Delta k.$$

Möchte man eine bestimmte Auflösung bspw. in x- Richtung $\Delta x$ erzielen sind also entsprechend Daten insbesondere unter Anlegen eines bestimmten maximalen Gradientenmomentes $G_x$ zu akquirieren. Werden weniger Datenpunkte aufgenommen wird die Auflösung geringer. Wird $G_x$ unterschritten, was eine Vergrößerung von $\Delta k$ nach sich zieht, kommt es zu Aliasing-Artefakten.

Das Nyquist-Theorem setzt lediglich eine Bandbegrenzung des abzutastenden Signals voraus. Es wird keinerlei sonstiges Vorwissen vorausgesetzt oder verwendet.

Aus den akquirierten Signalen $S(\omega)$ im k-Raum kann ein Signal oder Bild S(t) im Ortsraum durch eine Fouriertransformation FT ermittelt werden:

$$S(t) \ = \ 1/(2\pi) \ \int S(\omega) e^{i\omega t} d\omega.$$

Dies kann man auch ausdrücken als:

$$S(t) \ = \ FT \cdot S(\omega). \ (1)$$

Vorwissen kann auf mehrere Arten verwendet werden, um die durch das Nyquist-Theorem gesetzte Begrenzung zu umgehen.

Ein erster Ansatz ist die parallele Bildgebung. Diese weist zwei Bestandteile auf. Zum einen wird ein unterabgetasteter Datensatz aufgenommen, dafür aber mit mehreren Spulen.

Dadurch erhält man für jede Spule einen Bilddatensatz mit Einfaltungen. Unter Berücksichtigung der Sensitivität der Spulen als Vorwissen können diese Bilder zu einem einfaltungsfreien Bilddatensatz rekonstruiert werden. Bei SENSEbasierten Rekonstruktionsverfahren findet die Entfaltung im Bildraum statt, bei GRAPPA-basierten Rekonstruktionsverfahren im k-Raum.

Der erste Teil der parallelen Bildgebung besteht also aus der spezifischen Datenaufnahme, der zweite Teil aus einem speziellen Rekonstruktionsverfahren.

Eine weitere Möglichkeit Vorwissen zu benutzen und so die Grenzen des Nyquist-Theorems zu umgehen ist das sogenannte Compressed Sensing. Dieses stammt ursprünglich aus der Informationstheorie und wurde für fotographische Bilddatensätze entwickelt. Beispielhafte Ausführungsformen von Verfahren, die Compressed Sensing verwenden, sind in den Druckschriften US 8879852 B2, US 9784812 B2, DE 102013213940 B3, US 20160146915 A1, US 9396562 B2 und US 8275294 B2 beschrieben.

Die Grundidee rührt daher, dass bei der Komprimierung unkomprimiert aufgenommener Bilder ausgenutzt wird, dass diese bei einer Transformation eine Darstellung der Bilddaten mit wenig Koeffizienten erlaubt. Bei der JPEG2000-Komprimierung wird die Wavelet-Transformation benutzt.

Wenn man aber am Ende einen Teil der aufgenommenen Daten gar nicht benötigt stellt sich natürlich die Frage, ob man nicht die Aufnahme dieses Teils der Daten von vornherein auslassen kann. Dies ist möglich, und zwar bei Erfüllung bestimmter Voraussetzungen.

Eine Voraussetzung ist, dass das Signal "sparse", in etwa mit dünnbesetzt zu übersetzen, ist. Die "sparsity" kann dabei von vornherein gegeben sein. Ein bekanntes Beispiel sind Angiographie-Datensätze, bei denen die Gefäße nur wenige Bildelemente des Bildes belegen und die anderen Bildpunkte, auch wenn sie nicht nur ausschließlich Rauschsignal aufweisen, keinerlei relevante Information enthalten.

Die sparsity kann aber auch erzeugt werden durch eine Transformation. Bei vielen Fragestellungen kommt es nur auf bestimmte Bildbereiche oder Kanten an. Auch diese belegen nur wenige Bildelemente.

Beim Compressed Sensing wird nur ein Teil der k-Raum-Zeilen aufgenommen. Statt einer vollständigen Abtastung $S(\omega)$ hat man nur eine Unterabtastung $S_u(\omega)$ und statt einer quadratischen Fouriermatrix FT eine partielle Matrix P:

$$S_u(\omega) \;=\; P \cdot S(t). \quad (2)$$

Die Inversion von Gleichung (2) führt daher nicht zu einer eindeutigen Lösung wie Gleichung (1) sondern es wird ein Lösungsraum U aufgespannt.

Um in diesem Lösungsraum eine Lösung auszuwählen kann man ein Optimierungsverfahren verwenden. Eine Möglichkeit besteht darin, die Lösung mit minimaler Energie unter der euklidischen $l_2$-Norm aus dem Lösungsraum auszuwählen. Das entspricht einer Minimierung:

$$\min_{S(t)} \; \big\| S(t) \big\|_2 \quad \text{unter } P \cdot S(t) = S_u(\omega)$$

Zur Vereinfachung der Berechnung kann auch auf die $l_1$-Norm ausgewichen werden:

$$\min_{S(t)} \; \big\| S(t) \big\|_1 \quad \text{unter } P \cdot S(t) = S_u(\omega)$$

Da reale Daten Rauschsignal aufweisen wird die Bedingung folgendermaßen umgestellt:

$$\min_{S(t)} \; \big\| S(t) \big\|_1 \quad \text{unter } \big\| P \cdot S(t) - S_u(\omega) \big\|_2 \leq \varepsilon \quad (3)$$

Schreibt man Gleichung (3) als echte Gleichung und nicht als Ungleichung und in Lagrange-Form, so ergibt sich:

$$\operatorname*{argmin}_{S(t)} \; \big\| P \cdot S(t) - S_u(\omega) \big\|_2^2 + \lambda \big\| S(t) \big\|_1$$

Der Parameter $\lambda$ wird Regularisierungsparameter genannt und legt das Verhältnis von Datenkonsistenz zu sparsity fest. Ist er zu hoch wird zwar das Rauschsignal beseitigt aber auch zu viel Bildsignal. Ist er zu klein wird kaum Rauschsignal aus dem Bild entfernt.

Das Rauschen rührt von der Art der Abtastung her. Beim Compressed Sensing werden die k-Raum-Zeilen inkohärent aufgenommen, d.h. randomisiert oder auch pseudorandomisiert. D.h. dass die k-Raum-Zeilen in unregelmäßigen Abständen aufgenommen werden. Dadurch wird das Entstehen von Einfaltungen vermieden, allerdings sinkt das SNR ab.

Dieses durch die Unterabtastung und die Aufnahmestrategie erzeugte Rauschen wird bei der Erzeugung des Bilddatensatzes dann wieder entfernt.

Die Einstellung des Regularisierungsparameters ist dabei Vorgang, der viel Erfahrung erfordert. Das richtige $\lambda$

hängt bspw. auch von der sparsity, also des Informationsanteils im Bild, ab.

Aus HUANG F, CHEN Y: "Self-adjusted regularization ratio for robust compressed sensing", PROCEEDINGS OF THE INTERNATIONAL SOCIETY FOR MAGNETIC RESONANCE IN MEDICINE, 18. April 2009 (2009-04-18), Seite 4592, XP040611823 beschreibt ein Rekonstruktionsverfahren, bei dem ein Regularisierungsterm $2\lambda\sigma^2$ die Abhängigkeit der Datenrekonstruktion vom Regularisierungsparameter $\lambda$ verringert.

JAN AELTERMAN ET AL: "Automatic High-Bandwidth Calibration and Reconstruction of Arbitrarily Sampled Parallel MRI", PLOS ONE, Bd. 9, Nr. 6, 10. Juni 2014 (2014-06-10), Seite e98937, XP055526936, DOI: 10.1371/journal.pone.0098937 offenbart einen MR-Rekonstruktionsalgorithmus für Datensätze, die mittels paralleler Bildgebung aufgenommen wurden. Die Rekonstruktion verwendet eine an Compressed Sensing angelehnte Iteration.

KEDAR KHARE ET AL: "Accelerated MR imaging using compressive sensing with no free parameters: Accelerated MR Imaging using Compressive Sensing", MAGNETIC RESONANCE IN MEDICINE, Bd. 68, Nr. 5, 20. Januar 2012 (2012-01-20), Seiten 1450-1457, XP055525216, US ISSN: 0740-3194, DOI: 10.1002/mrm.24143) zeigt ein neues Verfahren zur automatischen Rekonstruktion unterabgetasteter Daten. Dabei wird ein weicher Schwellenwert eingesetzt.

KIEREN GRANT HOLLINGSWORTH: "Reducing acquisition time in clinical MRI by data undersampling and compressed sensing reconstruction", PHYSICS IN MEDICINE AND BIOLOGY, INSTITUTE OF PHYSICS PUBLISHING, BRISTOL GB, Bd. 60, Nr. 21, 8. Oktober 2015 (2015-10-08), XP020290393, ISSN: 0031-9155 werden Verfahren mit Kombination von paralleler Bildgebung und Compressed Sensing beschrieben.

Es ist daher Aufgabe der vorliegenden Erfindung, ein Verfahren zur Erzeugung eines Magnetresonanz-Bilddatensatzes anzugeben, das eine vereinfachte Compressed-Sensing-Rekonstruktion erlaubt.

Diese Aufgabe wird gelöst durch ein Verfahren zur Erzeugung eines Magnetresonanz-Bilddatensatzes mit den Schritten:

- Bereitstellen eines Rohdatensatzes, wobei der Rohdatensatz zeitlich und/oder räumlich unterabgetastet aufgenommen worden ist,
- Bereitstellen von Messsignalen einer Phasenkorrekturmessung,
- automatisierte Ermittlung eines Regularisierungsparameters, und
- Erzeugung eines Bilddatensatzes aus dem Rohdatensatz unter Verwendung des Regularisierungsparameters in einem Compressed-Sensing-Verfahren,
  dadurch gekennzeichnet, dass
- der Regularisierungsparameter aus wenigstens zwei Echosignalen ermittelt wird und
- die Echosignale aus den Messsignalen der Phasenkorrekturmessung verwendet werden
- die Aufnahme des Rohdatensatzes und die Phasenkorrekturmessung mit Hilfe einer TSE-Sequenz erfolgt.

Bekanntermaßen werden in der Magnetresonanztomographie keine Bildelemente direkt aufgenommen wie bspw. in der Fotografie, sondern Echosignale oder FIDs. Diese werden auch als Rohdatensatz bezeichnet. Aus einem Rohdatensatz können mit bekannten Rekonstruktionsverfahren dann Bilddatensätze erhalten werden.

Bei einem Turbospinecho TSE sind zum Beispiel die Echosignale umzusortieren, bevor sie fouriertransformiert werden können. Bei einer nichtkartesischen Abtastung des k-Raums kann ein Regridding vorgenommen werden.

Bei einer pseudorandomisierten Abtastung des k-Raums kann ein Compressed-Sensing-Rekonstruktionsverfahren zur Rekonstruktion eines Bilddatensatzes aus dem Rohdatensatz oder einem Zwischenbilddatensatz verwendet werden. Bei einer Unterabtastung in zeitlicher Dimension spricht man, wenn mehrere Bilddatensätze unterschiedliche Zeitpunkte einer Bewegung oder Zustandes darstellen und dabei Messdaten, die man zur Erfüllung des Nyquist-Theorems bräuchte, ausgelassen werden. Eine räumliche Unterabtastung liegt vor, wenn für einen einzigen Bilddatensatz nicht genügend k-Raum-Daten vorliegen.

Eine Unterabtastung kann auch in zeitlicher und räumlicher Dimension gleichzeitig vorliegen.

Ein Compressed-Sensing-Rekonstruktionsverfahren enthält üblicherweise die Bestandteile "transform sparsity" und eine nichtlineare, iterative Rekonstruktion. Bei dem Schritt "transform sparsity" wird der Rohdatensatz oder ein Zwischenbilddatensatz in eine Darstellung überführt, in dem das relevante Signal "sparse" ist.

Dann kann das Rauschsignal im nichtlinearen Rekonstruktionsverfahren unterdrückt werden. Je höher ein zu wählender Schwellenwert gesetzt wird, desto mehr Rauschsignal aber auch relevantes Signal wird entfernt. Dies ist über den Regularisierungsparameter $\lambda$ steuerbar. Damit das Compressed-Sensing-Rekonstruktionsverfahren fehlerfrei und optimiert arbeitet wird der Regularisierungsparameter $\lambda$ automatisiert ermittelt. Automatisiert ermittelt bedeutet dabei, dass der Zahlenwert des Regularisierungsparameters nicht völlig frei eingegeben werden muss. Eine völlig freie Eingabe, wie sie aus dem Stand der Technik bekannt ist, ist beispielsweise ein Zahlenfeld, in dem der Wert des Regularisierungsparameters einzugeben ist. Alternativ kann eine völlig freie Eingabe mittels eines Schiebereglers erfolgen, bei dem lediglich ein unterer und ein oberer Maximalwert die Eingabe begrenzen.

Bei einer automatisierten Ermittlung kann noch eine begrenzte Beeinflussungsmöglichkeit durch einen Benutzer bestehen, muss aber nicht.

Die Ermittlung des Regularisierungsparameters erfolgt also zumindest teilweise oder vollständig in einer Steuerungseinrichtung. Die beschriebenen Gleichungen sind in einem Datenspeicher hinterlegt und können mittels einer Software zur Berechnung des Regularisierungsparameters verwendet werden.

Dabei gelten alle Merkmale, die zum Stand der Technik in Bezug auf Compressed Sensing beschrieben wurden, auch für das erfindungsgemäße Verfahren fort mit Ausnahme der Festlegung des Regularisierungsparameters $\lambda$. Insbesondere können die k-Raum-Zeilen des Rohdatensatzes inkohärent, d.h. randomisiert oder auch pseudorandomisiert, aufgenommen werden.

Dabei wird der Regularisierungsparameter $\lambda$ aus wenigstens zwei Echosignalen ermittelt. Die Echosignale können grundsätzlich aus einer Referenzmessung oder dem Rohdatensatz stammen. Referenzmessungen sind Messungen zur Ermittlung von Messparametern oder Korrekturfaktoren.

Erfindungsgemäß werden die Echosignale aus einer Phasenkorrekturmessung verwendet. Diese Messung wird sowieso durchgeführt und verursacht daher keinen Zusatzaufwand.

Vorteilhafterweise werden genau zwei Echosignale verwendet.

Alternativ werden genau drei Echosignale verwendet. Es hat sich überaschenderweise herausgestellt, dass sich der Regularisierungsparameter $\lambda$ bereits mit einer geringen Anzahl an Echosignalen bestimmen lässt.

Bei der Verwendung mehrerer Empfangsspulen ist zu konkretisieren, dass zwei oder drei Messsignale pro Empfangsspule verwendet werden.

Bevorzugt kann jeweils eine Signalamplitude des Echosignals verwendet werden. Insbesondere kann zur Ermittlung des Regularisierungsparameters jeweils die maximale Signalamplitude des Echosignals verwendet werden. Diese befindet sich in der Regel in der Mitte des Echosignals. Ebenso kann die Signalamplitude im Zentrum des k-Raums verwendet werden. Alternativ kann auch ein anderer Referenzwert der Echosignale eingesetzt werden. Beispielsweise kann auch die Fläche unter dem Echosignal, der Mittelwert aller Signalamplituden des Echosignals, wobei jeweils der Betragswert verwendet wird, oder der Mittelwert einer bestimmten Anzahl von Signalamplituden aus der Mitte des Echosignals verwendet werden.

Die Echosignale werden in einem Echozug aufgenommen. Dieser kann entweder phasengradientenfrei und damit phasenkodierungsfrei aufgenommen werden. Dann geben die Echosignale den $T_2$-Abfall wieder. Alternativ kann ein Phasengradientenverlauf verwendet werden. Dieser entspricht vorzugsweise einem bei der Aufnahme des Rohdatensatzes verwendeten Phasengradientenverlauf.

Erfindungsgemäß wird ein TSE-Phasengradientenverlauf verwendet. Bei TSE-Sequenzen kann die Abtastung des k-Raums auch bei einer kartesischen Abtastung unterschiedlichen Schemata folgen. In einer ersten Ausgestaltung kann der k-Raum "centered" abgetastet werden. Dann wird der k-Raum immer vom Zentrum nach außen abgetastet. Alternativ kann der k-Raum "linear" abgetastet werden. Dann beginnt die Abtastung am Rand des k-Raums und wandert über das Zentrum wieder nach außen. Weiter alternativ kann die Abtastung zwischen einem ersten Rand und dem Zentrum anfangen und über den anderen Rand hinausgehen und am ersten Rand die letzten Echosignale des Echozugs enthalten.

Bevorzugt kann aus wenigstens zwei Echosignalen bzw. deren Referenzwert der arithmetische Mittelwert bestimmt werden.

Vorteilhafterweise können wenigstens zwei Echosignalen bzw. deren Referenzwerte addiert werden. Addieren ist hier mathematisch zu verstehen und umfasst sowohl die Summation als auch Differenzwertbildung.

In einer Ausgestaltung kann aus den maximalen Signalamplituden der Echosignale am Anfang und Ende des Echozugs der Mittelwert gebildet werden. Zu diesem Mittelwert wird die größte Signalamplitude, also des Echosignals aus dem Zentrum des k-Raums, hinzugefügt. Sind $I_{max\_A}$ die Signalamplitude des ersten Echos des Echozuges, $I_{max\_B}$ die Signalamplitude des letzten Echos des Echozuges und $I_{max\_M}$ die Signalamplitude des Echos mit der größten Signalamplitude im Echozug, dann ergibt sich der Regularisierungsparameter $\lambda$ zu:

$$\lambda = \lambda(\ I_{max\_M}\ +\ 1/2(I_{max\_A}\ +\ I_{max\_B})).\ (4)$$

Der Regularisierungsparameter wird also in Abhängigkeit oder anders ausgedrückt als Funktion von $I_{max\_M}$, $I_{max\_A}$ und $I_{max\_B}$ ermittelt, wobei von $I_{max\_A}$ und $I_{max\_B}$ der Mittelwert verwendet wird und dieser positiv zu $I_{max\_M}$ addiert wird. Anders gesagt ist der Regalarisierungsparameter eine Funktion von $I_{max\_M}$, $I_{max\_A}$ und $I_{max\_B}$. Diese Festlegung des Regularisierungsparameters wird bei der Verwendung eines Turbospinecho als Bildgebungssequenz eingesetzt .

Bevorzugt können die Echosignale mit wenigstens zwei verschiedenen Spulen aufgenommen werden. Dann kann der Regularisierungsparameter zusätzlich oder alternativ in Abhängigkeit der aufnehmenden Spule gewichtet werden:

$$\lambda_{coil} = \lambda(I_{max\_coil}).\ (5)$$

Dies kann mit der ersten Ausgestaltung kombiniert werden, indem beispielsweise der Echozug mit jeder Spule aufgenommen wird und die Berechnung des Regularisierungsparameters $\lambda$ wie in Gleichung (4) vorgegeben für jede Spule durchgeführt wird. Je nach Ausgestaltung des Rekonstruktionsverfahrens kann für jeweils einen mit einer Spule akquirierten Rohdatensatz der jeweilige Regularisierungsparameter $\lambda_{coil}$ verwendet werden. Werden die Spulen für parallele Bildgebung verwendet und ein entfaltetes Bild berechnet, kann auch ein Gesamt-Regularisierungsparameter für eine Anzahl von n Spulen ermittelt werden:

$$\lambda_{coil} = 1/n \cdot (\alpha_1 \lambda_{coil\_1} + \alpha_2 \lambda_{coil\_2} + \dots + \alpha_n \lambda_{coil\_n}). \quad (6)$$

Die Koeffizienten $\alpha$ sind dabei Wichtungsfaktoren, die den Eingang der einzelnen Spulensignale in das Gesamtbild wiedergeben.

Alternativ kann ein Gesamt-Regularisierungsparameter erhalten werden, indem ein quadratischer Mittelwert der Signalamplituden berechnet wird:

$$I_{coil\_gesamt} = SQRT(\ I_{max\_coil\_1}^2 + I_{max\_coil\_2}^2 + \dots + I_{nax\_coil\_n}^2) \quad (7)$$

und der Gesamt-Regularisierungsparameter $\lambda_{coil}$ dann in Abhängigkeit des Mittelwertes $I_{coil\_gesamt}$ ermittelt wird:

$$\lambda_{coil} = \lambda(I_{coil\ gesamt}). \quad (8)$$

Alternativ oder zusätzlich kann wenigstens eines der Echosignale unter Verwendung eines Präparationsmoduls aufgenommen werden. Der Regularisierungsparameter ergibt sich dann zu

$$\lambda = \lambda(I_{ohne} - I_{mit}). \quad (9)$$

Bei dieser negativen Addition werden die maximalen Signalintensitäten oder ein anderer Referenzwert der Echosignale einmal mit Präparationsmodul und einmal ohne Präparationsmodul akquiriert. Die Messung ohne Präparationsmodul erzeugt die maximale Signalintensität $I_{ohne}$. Die maximale Signalintensität des mit vorausgehendem Präparationsmodul aufgenommenen Echosignals wird $I_{mit}$ genannt. Die Messdaten $I_{ohne}$ können aus einer Referenzmessung ohne Präparationsmodul oder aus der Messung der Bilddaten stammen.

Weiterhin kann alternativ das Verhältnis einer Messung mit und ohne Präparationsmodul benutzt werden:

$$\lambda = \lambda(I_{ohne} / I_{mit}). \quad (10)$$

Die Berücksichtigung eines Präparationsmoduls kann sowohl mit der Aufnahme eines Echozuges als auch mit der Verwendung mehrerer Spulen kombiniert werden. So kann die in Gleichung (7) ermittelte Signalintensität einmal mit und einmal ohne Präparationsmodul ermittelt werden und diese Werte dann in Gleichung (9) verwendet werden.

Als weitere Ausgestaltung kann vorgesehen sein, dass dem Benutzer ein Bedienfeld angezeigt wird. Dabei können mehrere Vorgaben als Auswahlliste angezeigt werden. Zur Auswahl können die Varianten "sharp", "medium" und "smooth" gestellt werden.

Die Auswahl der Variante "sharp" führt dann dazu, dass der automatisch berechnete Regularisierungsparameter $\lambda$ umgerechnet wird zu:

$$\lambda` = 1/x \cdot \lambda \quad (11).$$

Bei der Auswahl der Variante "medium" kann der Regularisierungsparameter $\lambda$ beibehalten werden:

$$\lambda` = \lambda \quad (12).$$

Wird dagegen die Variante "smooth" ausgewählt, wird der Regularisierungsparameter $\lambda'$ festgesetzt zu:

$$\lambda` = x \cdot \lambda \quad (13).$$

Der Umrechnungsfaktor x ist grundsätzlich frei einstellbar und liegt vorzugsweise zwischen 1 und 10. Auf diese Art und Weise kann der Benutzer trotz der automatisierten Ermittlung des Regularisierungsparameters $\lambda$ noch auf die

Rekonstruktion des Bilddatensatzes Einfluss nehmen, ohne sich mit dem Wesen des Regularisierungsparameters befassen zu müssen oder ihn überhaupt kennen zu müssen.

In einer weiteren Alternative kann der Benutzer zwischen einer statischen und einer dynamischen Messung auswählen, was einem räumlichen oder zeitlichen Unterabtasten entspricht. Dann kann ein Zwischen-Regularisierungsparameter mittels eines Schiebereglers ausgewählt werden und der Regularisierungsparameter im Fall einer statischen Messung ermittelt werden zu:

$$\lambda = z \cdot \sigma \quad (14)$$

wobei z ein frei wählbarer, konstanter Faktor und $\sigma$ der am Schieberegler eingestellte Wert ist. Im Fall einer dynamischen Messung wird der Regularisierungsparameter $\lambda$ dagegen folgendermaßen bestimmt:

$$\lambda = z \cdot \log(y \cdot \sigma) \quad (15)$$

Auch hier sind y und z frei wählbare, konstante Faktoren und $\sigma$ der am Schieberegler eingestellte Wert.

Vorzugsweise kann der Rohdatensatz mit mehreren Spulen aufgenommen werden. Er kann dann noch stärker unterabgetastet werden als es mit Compressed Sensing alleine möglich wäre.

Erfindungsgemäß wird als Messsequenz zur Aufnahme des Messdatensatzes eine Turbospinecho-Sequenz verwendet .

Diese umfasst zur Bildgebung im Unterschied zur weiter unten beschriebenen Sequenz auch Phasenkodierungsgradienten.

Vorzugsweise kann der k-Raum bei der Aufnahme des Rohdatensatzes kartesisch abgetastet werden. Dies ist beispielsweise bei einer räumlichen bzw. statischen Unterabtastung möglich. Alternativ kann der k-Raum bei der Aufnahme des Rohdatensatzes radial abgetastet werden. Diese Art der Unterabtastung ist insbesondere bei einer zeitlichen Unterabtastung vorteilhaft. Es können einzelne Spokes mehreren Rohdatensätzen zugeordnet werden.

Weiter alternativ kann der k-Raum bei der Aufnahme des Rohdatensatzes spiral abgetastet werden. Mit einer spiralen Abtastung lassen sich große zeitliche Beschleunigungen erzielen.

Bevorzugt ist der Rohdatensatz in räumlicher Dimension, d.h. statisch, unterabgetastet. Bei dieser Art der Unterabtastung ist die automatische Vorgabe der Regularisierungsparameters besonders hilfreich.

Die Lösung der eingangs genannten Aufgabe wird außerdem durch ein Computerprogrammprodukt bzw. ein Computerprogramm nach Anspruch 13 erzielt Daneben betrifft die Erfindung einen Datenträger gemäß Anspruch 14. Vorteilhafterweise kann die Datenerzeugungseinheit eine Bilderzeugungseinheit sein.

Daneben betrifft die Erfindung eine Magnetresonanzanlage mit einer Steuerungseinrichtung. Die Magnetresonanzanlage zeichnet sich dadurch aus, dass die Steuerungseinrichtung zur Durchführung des Verfahrens wie beschrieben ausgebildet ist. Die Implementierung der vorgenannten Verfahren in der Steuervorrichtung kann dabei als Software oder aber auch als (fest verdrahtete) Hardware erfolgen.

Weitere vorteilhafte Ausgestaltungen der erfindungsgemäßen Magnetresonanzanlage korrespondieren zu entsprechenden Ausgestaltungen des erfindungsgemäßen Verfahrens. Zur Vermeidung unnötiger Wiederholungen wird somit auf die entsprechenden Verfahrensmerkmale und deren Vorteile verwiesen.

Weitere Vorteile, Merkmale und Besonderheiten der vorliegenden Erfindung ergeben sich aus der nachfolgenden Beschreibung vorteilhafter Ausgestaltungen der Erfindung.

Dabei zeigen:

Fig. 1    eine Magnetresonanzanlage,

Fig. 2    eine Messsequenz,

Fig. 3    einen Echozug,

Fig. 4    ein Echosignal in einer ersten Ausgestaltung,

Fig. 5    ein erstes Spektrum,

Fig. 6    ein zweites Spektrum,

Fig. 7    ein Echosignal in einer zweiten Ausgestaltung, und

Fig. 8    ein Bedienfeld.

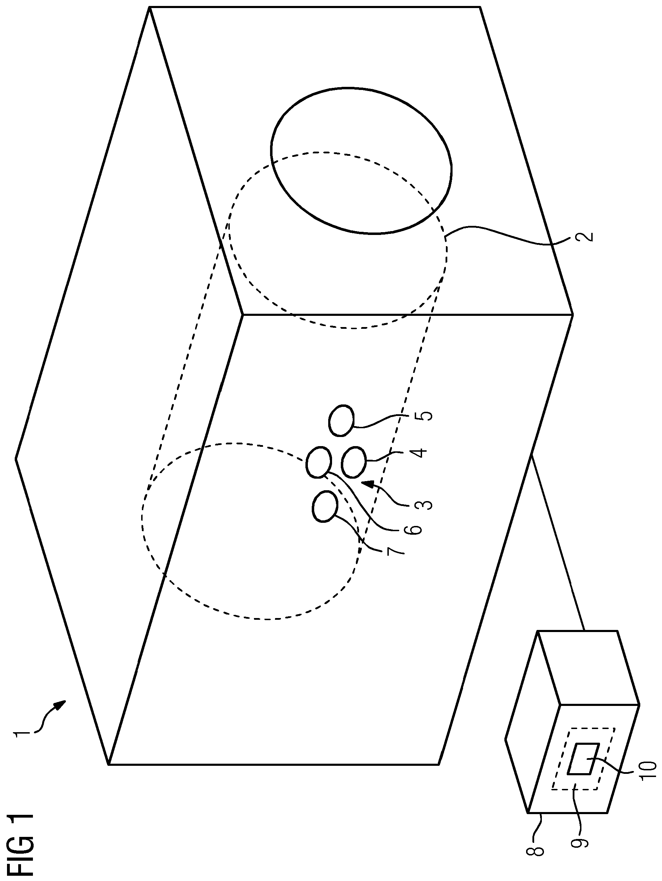

Figur 1 zeigt eine Magnetresonanzanlage 1 mit einer Sendespulenanordnung 2. Die Sendespulenanordnung 2 kann als Bodycoil ausgestaltet sein. Es kann sich dabei aber auch um ein Sendespulenarray handeln. Die Sendespulenanordnung 2 ist gestrichelt dargestellt.

Zur Datenakquisition besitzt die Magnetresonanzanlage 1 eine Empfangsspulenanordnung 3. Die Empfangsspulenanordnung 3 ist vorzugsweise ein Spulenarray mit Spulen 4, 5, 6 und 7. Die Spulen 4, 5, 6 und 7 lesen Messsignale gleichzeitig und damit parallel aus.

Zur Steuerung der Experimente weist die Magnetresonanzanlage 1 eine Steuerungseinrichtung 8 auf.

Die Magnetresonanzanlage 1 besitzt weiterhin einen Datenträger 9 als Teil der Steuerungseinrichtung 8 oder unabhängig davon, auf dem Computerprogramme 10 zur Durchführung von Magnetresonanzmessungen abgespeichert sind.

Weitere Bestandteile der Magnetresonanzanlage 1 wie bspw. Gradientenspulen oder eine Patientenliege sind der Übersichtlichkeit halber nicht dargestellt.

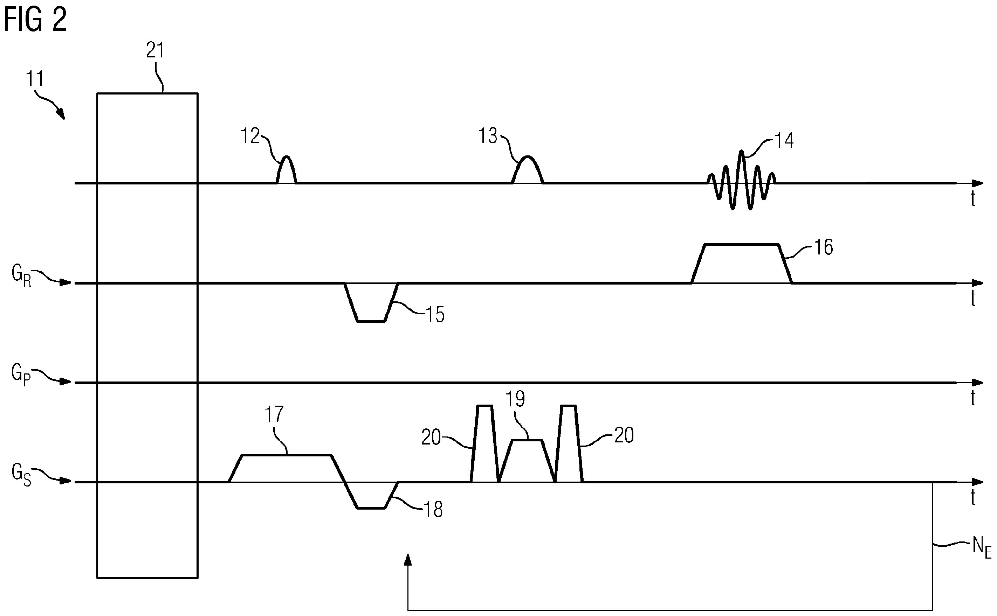

Figur 2 zeigt eine TSE-Messsequenzdiagramm 11. Die Turbospinechosequenz dient zur Aufnahme von Messsignalen zur Phasenkorrektur. Der Echozug mit einer Anzahl von $N_E$ Echos wird ohne Phasenkodierung und damit ohne Gradienten in Phasenkodierrichtung $G_P$ aufgenommen.

ACQ bezeichnet die Achse für die Hochfrequenzimpulse und die Akquisitionsfenster. Der Hochfrequenzimpuls 12 ist üblicherweise ein 90°-Impuls und der Refokussierungsimpuls 13 ein 180°-Impuls. Diese erzeugen die Echosignale 14.

In Leserichtung $G_R$ liegen ein Lese-Dephasiergradient 15 und Lesegradienten 16 an.

In Schichtauswahlrichtung $G_S$ liegt gleichzeitig zum Hochfrequenzimpuls 12 ein Schichtauswahlgradient 17 an, dem ein Schicht-Rephasiergradient 18 folgt. Der Schicht-Rephasiergradient 18 besitzt üblicherweise das halbe Gradientenmoment im Vergleich zum Schichtauswahlgradienten 17.

Gleichzeitig zum Refokussierungsimpuls 13 liegt der Schichtauswahlgradient 19 an. Dieser ist von zwei Spoilergradienten umfasst. Die Spoilergradienten 20 dienen der Zerstörung von Signalanteilen, die aufgrund von Imperfektionen des Refokussierungsimpulses 13 entstehen können.

Vor dem Hochfrequenzimpuls 12 kann wahlweise ein Präparationsmodul 21 eingesetzt werden.

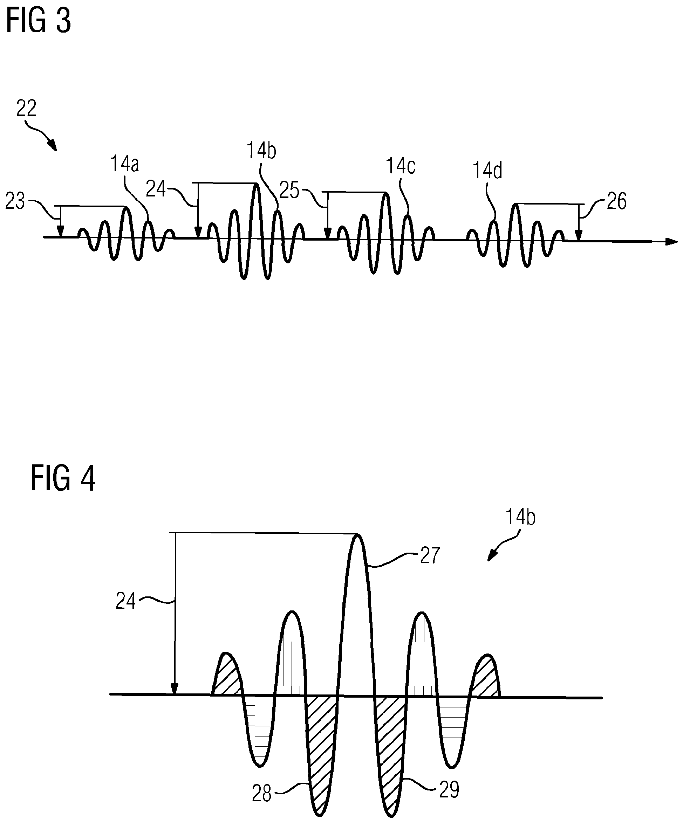

Figur 3 zeigt einen Echozug 22, wie er mit der TSE-Sequenz nach Figur 2 erhalten werden kann. Der Echozug 22 umfasst rein exemplarisch vier Echosignale 14a, 14b, 14c und 14d.

Die Signalintensität oder -amplitude $I_{max\_A}$ des ersten Echosignals 14a wird dabei mittels des Pfeils 23 angezeigt, die Signalamplitude $I_{max}$ des letzten Echosignals 14d mittels des Pfeils 26. Die Pfeile 24 und 25 zeigen die Signalamplituden der Echosignale 14b und 14c an. Der Pfeil 24 zeigt dabei die Signalamplitude $I_{max\_M}$ an, da diese per Definition die größte Signalamplitude im Echozug 22 ist.

Anhand der TSE-Messsequenz nach Figur 2 kann der Regularisierungsparameter $\lambda$ also wie in Formel (4) angegeben berechnet werden:

$$\lambda = \lambda(\ I_{max\_M}\ +\ 1/2(I_{max\_A}\ +\ I_{max\_B})).$$

Figur 4 zeigt das Echosignal 14b vergrößert. An diesem sollen mehrere aus einem Echosignal ableitbare Referenzwerte dargestellt werden.

Wie oben bereits beschrieben kann die maximale Amplitude $I_{max}$ des Echosignals 14b verwendet werden. Alternativ kann auch die Fläche des Echosignalanteils 27 berücksichtigt werden. Weiter alternativ können auch weitere Signalanteile wie die Signalanteile 28 und 29 einbezogen werden. Verallgemeinert kann also das Integral eines Teils des Echosignals 14b verwendet werden.

Der Referenzwert der Echosignale 14a, 14b, 14c und 14d ist zwar per se frei wählbar, muss aber für alle Echosignale 14a, 14b, 14c und 14d gleich gewählt werden.

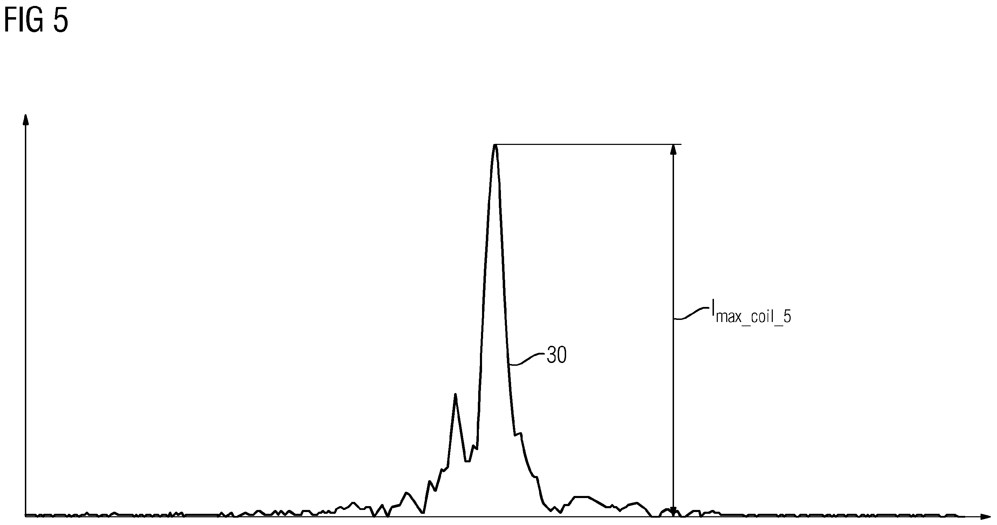

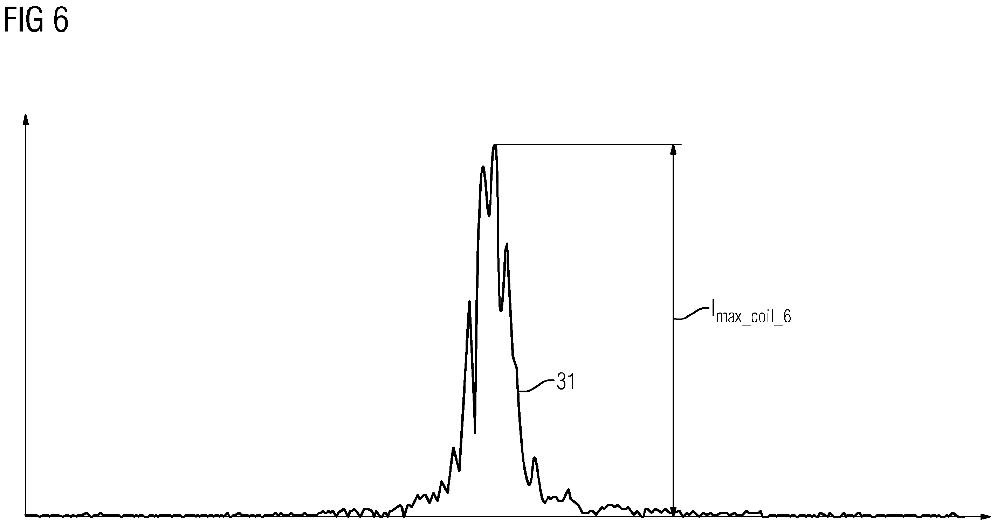

Die Figuren 5 und 6 zeigen Echosignale 30 und 31. Das Echosignal 30 wurde dabei bspw. mit der Spule 5 aufgenommen und das Echosignal 31 mit der Spule 6. Die Echosignale können dann wie in Formel (7) angegeben zu einem Gesamtsignal verrechnet werden:

$$I_{gesamt} = SQRT(I_{max\_coil\_4}^2\ +\ I_{max\_coil\_5}^2\ +\ I_{max\_coil\_6}^2\ +\ I_{max\_coil\_7}^2)$$

Dabei wird wie zu Figur 1 beschrieben rein exemplarisch von vier Empfangsspulen 4, 5, 6 und 7 ausgegangen. Diese geben auch die Indizes vor.

Statt einzelner Echosignale 30 und 31 kann auch ein Echozug 22 mit jeder Spule 4, 5, 6 und 7 gemessen werden und für jede Spule eine Referenzamplitude analog zu Gleichung (4) ermittelt werden. Diese Referenzamplitude kann dann in Gleichung (7) berücksichtigt werden.

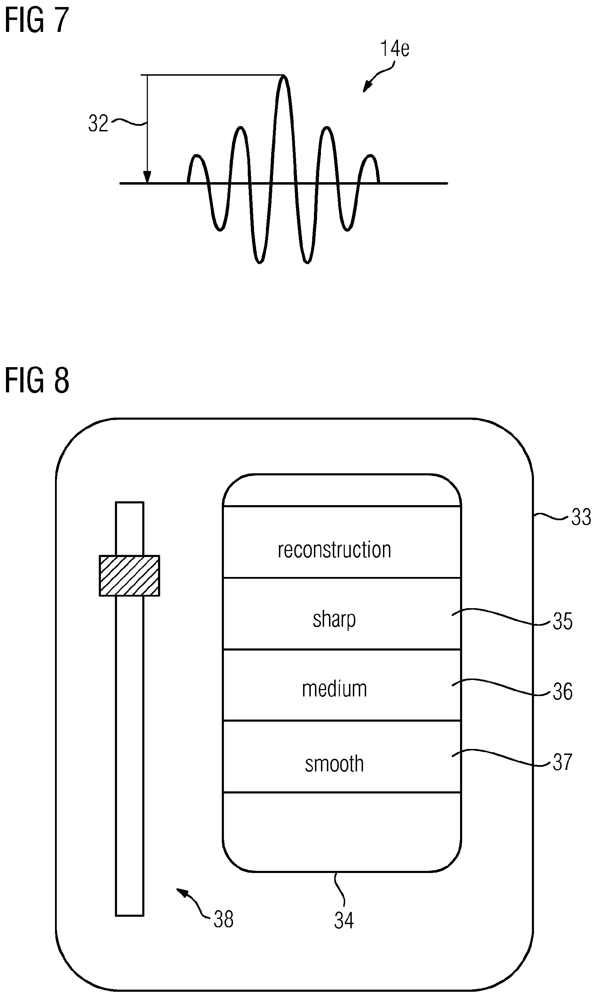

Figur 7 zeigt ein Echosignal 14e, das von der Aufnahme her mit dem Echosignal 14b vergleichbar ist. Im Unterschied zu diesem wurde vor der Erzeugung des Echosignals 14e das Präparationsmodul 21 angelegt. Dadurch hat sich die Signalamplitude $I_{max}$, dargestellt durch den Pfeil 32, verringert. Der Regularisierungsparameter $\lambda$ kann wie in Gleichung (9) angegeben ermittelt werden.

Figur 8 zeigt einen Teil eines Bedienfeldes 33. Dieses beinhaltet ein Dropdown-Menu 34 zur Modifikation des Regularisierungsparameters $\lambda$. Je nachdem welches der Auswahlfelder 35, 36 oder 37 ausgewählt wird, wird der Regularisierungsparameter $\lambda$ nach einer der Gleichungen (11) bis (13) modifiziert.

Daneben kann auch ein Schieberegler 38 zur Vornahme einer Grundeinstellung des Regularisierungsparameters $\lambda$ vorhanden sein.

**Patentansprüche**

1. Computerimplementiertes Verfahren zur Erzeugung eines Magnetresonanz-Bilddatensatzes mit den Schritten:

   - Bereitstellen eines Rohdatensatzes, wobei der Rohdatensatz zeitlich und/oder räumlich unterabgetastet aufgenommen worden ist,
   - Bereitstellen von Messsignalen einer Phasenkorrekturmessung,
   - automatisierte Ermittlung eines Regularisierungsparameters ($\lambda$), und
   - Erzeugung eines Bilddatensatzes aus dem Rohdatensatz unter Verwendung des Regularisierungsparameters ($\lambda$) in einem Compressed-Sensing-Verfahren,
   **dadurch gekennzeichnet, dass**
   - der Regularisierungsparameter ($\lambda$) aus wenigstens zwei Echosignalen (14a, 14b, 14c, 14d, 14e) ermittelt wird wobei die Echosignale aus den Messsignalen der Phasenkorrekturmessung verwendet werden,
   - die Aufnahme des Rohdatensatzes und die Phasenkorrekturmessung mit Hilfe einer TSE-Sequenz erfolgt ist

2. Verfahren nach Anspruch 1, **dadurch gekennzeichnet, dass** die Echosignale (14a, 14b, 14c, 14d, 14e) in einem Echozug (22) aufgenommen worden sind .

3. Verfahren nach einem der Ansprüche 1 oder 2, **dadurch gekennzeichnet, dass** zur Ermittlung des Regularisierungsparameters ($\lambda$) die maximale Signalamplitude ($I_{max\_M}$, $I_{max\_A}$, $I_{max\_B}$) der Echosignale (14a, 14b, 14c, 14d, 14e) verwendet wird.

4. Verfahren nach einem der vorangehenden Ansprüche, **dadurch gekennzeichnet, dass** die Echosignale (14a, 14b, 14c, 14d, 14e) mit wenigstens zwei verschiedenen Spulen (4, 5, 6, 7) aufgenommen worden sind.

5. Verfahren nach einem der vorangehenden Ansprüche, **dadurch gekennzeichnet, dass** der Regularisierungsparameter ($\lambda$) durch eine Addition von Signalamplituden ($I_{max\_M}$, $I_{max\_A}$, $I_{max\_B}$) ermittelt wird.

6. Verfahren nach einem der vorangehenden Ansprüche, **dadurch gekennzeichnet, dass** der Regularisierungsparameter ($\lambda$) durch eine Division von zwei Signalamplituden ($I_{ohne}$, $I_{mit}$) ermittelt wird.

7. Verfahren nach einem der vorangehenden Ansprüche, **dadurch gekennzeichnet, dass** wenigstens eines der Echosignale (14e), insbesondere genau eines, unter Verwendung eines Präparationsmoduls (21) aufgenommen worden ist.

8. Verfahren nach einem der vorangehenden Ansprüche, **dadurch gekennzeichnet, dass** der Regularisierungsparameter ($\lambda$) durch eine arithmetische Mittelwertbildung von Signalamplituden ($I_{max\_A}$, $I_{max\_B}$) ermittelt wird.

9. Verfahren nach einem der vorangehenden Ansprüche, **dadurch gekennzeichnet, dass** der Regularisierungsparameter ($\lambda$) durch eine quadratische Mittelwertbildung von Signalamplituden ($I_{max\_coil\_1}$, $I_{max\_coil\_2}$, $I_{max\_coil\_n}$) der Echosignale (14a, 14b, 14c, 14d, 14e) ermittelt wird.

10. Verfahren nach einem der vorangehenden Ansprüche, **dadurch gekennzeichnet, dass** die Echosignale (14a, 14b, 14c, 14d, 14e) phasenkodierungsfrei aufgenommen worden sind.

11. Verfahren nach einem der vorangehenden Ansprüche, **dadurch gekennzeichnet, dass** der Regularisierungspara-

meter ($\lambda$) über in Auswahlfeldern (35, 36, 37) auswählbare Rekonstruktionsvorgaben veränderbar ist.

12. Verfahren nach einem der vorangehenden Ansprüche, **dadurch gekennzeichnet, dass** das Compressed-Sensing-Verfahren eine nichtlineare, iterative Rekonstruktion umfasst.

13. Computerprogrammprodukt (10) für eine Steuerungseinrichtung (8) zur Steuerung einer Datenerzeugungseinheit, insbesondere einer Bilderzeugungseinheit, einer Magnetresonanzanlage (1) umfassend Befehle, die bei der Ausführung des Programms durch die Steuerungseinrichtung diese veranlassen, ein Verfahren gemäß einem der vorhergehenden Ansprüche auszuführen .

14. Computerlesbarer Datenträger (9) für eine Steuerungseinrichtung (8) zur Steuerung einer Datenerzeugungseinheit, insbesondere Bilderzeugungseinheit, einer Magnetresonanzanlage (1) auf dem das Computerprogrammprodukt nach Anspruch 13 gespeichert ist.

15. Magnetresonanzanlage (1) mit einer Steuerungseinrichtung (8), **dadurch gekennzeichnet, dass** die Steuerungseinrichtung (8) zur Durchführung eines Verfahrens nach einem der Ansprüche 1 bis 12 ausgebildet ist.

## Claims

1. Computer-implemented method for generating a magnetic resonance image dataset, comprising the steps:

   - providing a raw dataset, wherein the raw dataset has been acquired such that it is spatially and/or temporally undersampled,
   - providing measurement signals of a phase correction measurement,
   - determining a regularisation parameter ($\lambda$) in an automated manner, and
   - generating an image dataset from the raw dataset using the regularisation parameter ($\lambda$) in a compressed sensing technique,
   **characterised in that**
   - the regularisation parameter ($\lambda$) is determined from at least two echo signals (14a, 14b, 14c, 14d, 14e), wherein the echo signals from the measurement signals of the phase correction measurement are used,
   - the raw dataset and the phase correction measurement are acquired with the aid of a TSE sequence.

2. Method according to claim 1, **characterised in that** the echo signals (14a, 14b, 14c, 14d, 14e) have been acquired in an echo train (22).

3. Method according to one of claims 1 or 2, **characterised in that** the maximum signal amplitude ($I_{max\_M}$, $I_{max\_A}$, $I_{max\_B}$) of the echo signals (14a, 14b, 14c, 14d, 14e) is used to determine the regularisation parameter ($\lambda$).

4. Method according to one of the preceding claims, **characterised in that** the echo signals (14a, 14b, 14c, 14d, 14e) have been acquired using at least two different coils (4, 5, 6, 7).

5. Method according to one of the preceding claims, **characterised in that** the regularisation parameter ($\lambda$) is determined by adding signal amplitudes ($I_{max\_M}$, $I_{max\_A}$, $I_{max\_B}$).

6. Method according to one of the preceding claims, **characterised in that** the regularisation parameter ($\lambda$) is determined by dividing two signal amplitudes ($I_{without}$, $I_{with}$).

7. Method according to one of the preceding claims, **characterised in that** at least one of the echo signals (14e), in particular precisely one, has been acquired using a preparatory module (21).

8. Method according to one of the preceding claims, **characterised in that** the regularisation parameter ($\lambda$) is determined by forming the arithmetic mean of signal amplitudes ($I_{max\_A}$, $I_{max\_B}$).

9. Method according to one of the preceding claims, **characterised in that** the regularisation parameter ($\lambda$) is determined by forming the root mean square of signal amplitudes ($I_{max\_coil\_1}$, $I_{max\_coil\_2}$, $I_{max\_coil\_n}$) of the echo signals (14a, 14b, 14c, 14d, 14e).

10. Method according to one of the preceding claims, **characterised in that** the echo signals (14a, 14b, 14c, 14d, 14e) have been acquired without a phase encoding gradient.

11. Method according to one of the preceding claims, **characterised in that** the regularisation parameter ($\lambda$) can be changed by means of reconstruction presets that can be selected in selection fields (35, 36, 37).

12. Method according to one of the preceding claims, **characterised in that** the compressed sensing technique comprises a non-linear iterative reconstruction.

13. Computer program product (10) for a controller (8) for controlling a data generating unit, in particular an image generating unit, of a magnetic resonance system (1) comprising commands which, when the program is executed by the controller, cause this to perform a method according to one of the preceding claims.

14. Computer-readable data storage medium (9) for a controller (8) for controlling a data generating unit, in particular image generating unit, of a magnetic resonance system (1), on which the computer program product according to claim 13 is stored.

15. Magnetic resonance system (1) comprising a controller (8), **characterised in that** the controller (8) is designed to implement a method according to one of claims 1 to 12.

**Revendications**

1. Procédé mis en œuvre par ordinateur de production d'un ensemble de données d'image par résonance magnétique, comprenant les stades :

   - on se procure un ensemble de données brutes, l'ensemble de données brutes ayant été enregistré d'une manière sous-échantillonnée dans le temps et/ou dans l'espace,
   - on se procure des signaux de mesure d'une mesure de correction de phase,
   - détermination automatisée d'un paramètre ($\lambda$) de régularisation, et
   - production d'un ensemble de données d'image à partir de l'ensemble de données brutes en utilisant le paramètre ($\lambda$) de régularisation dans un procédé compressed-sensing,
   **caractérisé en ce que** l'
   - on détermine le paramètre ($\lambda$) de régularisation à partir d'au moins deux signaux (14a, 14b, 14c, 14d, 14e) d'écho dans lequel
   on utilise les signaux d'écho des signaux de mesure de la mesure de correction de phase,
   - l'enregistrement de l'ensemble de données brutes et la mesure de correction de phase sont effectués à l'aide d'une séquence TSE.

2. Procédé suivant la revendication 1, **caractérisé en ce que** l'on a enregistré les signaux (14a, 14b, 14c, 14d, 14e) d'écho dans un train (22) d'échos.

3. Procédé suivant l'une des revendications 1 ou 2, **caractérisé en ce que** pour la détermination du paramètre ($\lambda$) de régularisation, on utilise l'amplitude ($I_{max\_M}$, $I_{max\_A}$, $I_{max\_B}$) maximum de signal des signaux (14a, 14b, 14c, 14d, 14e) d'écho.

4. Procédé suivant l'une des revendications précédentes, **caractérisé en ce que** l'on a enregistré les signaux (14a, 14b, 14c, 14d, 14e) d'écho avec au moins deux bobines (4, 5, 6, 7) différentes.

5. Procédé suivant l'une des revendications précédentes, **caractérisé en ce que** l'on détermine le paramètre ($\lambda$) de régularisation par une addition d'amplitudes ($I_{max\_M}$, $I_{max\_A}$, $I_{max\_B}$) de signal.

6. Procédé suivant l'une des revendications précédentes, **caractérisé en ce que** l'on détermine le paramètre ($\lambda$) de régularisation par une division de deux amplitudes ($I_{ohne}$, $I_{mit}$) de signal.

7. Procédé suivant l'une des revendications précédentes, **caractérisé en ce que** l'on a enregistré au moins l'un des signaux (14e) d'écho, notamment exactement un, en utilisant un module (21) de préparation.

**8.** Procédé suivant l'une des revendications précédentes, **caractérisé en ce que** l'on détermine le paramètre ($\lambda$) de régularisation en formant une moyenne arithmétique d'amplitudes ($I_{max\_A}$, $I_{max\_B}$) de signal.

**9.** Procédé suivant l'une des revendications précédentes, **caractérisé en ce que** l'on détermine le paramètre ($\lambda$) de régularisation en formant une moyenne quadratique d'amplitudes ($I_{max\_coil\_1}$, $I_{max\_coil\_2}$, $I_{max\_coil\_n}$) de signal des signaux (14a, 14b, 14c, 14d, 14e) d'écho.

**10.** Procédé suivant l'une des revendications précédentes, **caractérisé en ce que** l'on a enregistré sans codage de phase les signaux (14a, 14b, 14c, 14d, 14e) d'écho.

**11.** Procédé suivant l'une des revendications précédentes, **caractérisé en ce que** le paramètre ($\lambda$) de régularisation peut être modifié par des prescriptions de reconstruction pouvant être sélectionnées dans des champs (35, 36, 37) de sélection.

**12.** Procédé suivant l'une des revendications précédentes, **caractérisé en ce que** le procédé compressed-sensing comprend une reconstruction itérative non linéaire.

**13.** Produit (10) de programme d'ordinateur pour un dispositif (8) de commande pour la commande d'une unité de production de données, en particulier d'une unité de production d'images, d'une installation (1) de résonance magnétique, comprenant des instructions, qui lors de l'exécution du programme par le dispositif de commande, font que celui-ci exécute un procédé suivant l'une des revendications précédentes.

**14.** Support (9) de données déchiffrable par ordinateur pour un dispositif (8) de commande pour la commande d'une unité de production de données, en particulier d'une unité de production d'images d'une installation (1) de résonance magnétique, sur lequel le produit de programme d'ordinateur suivant la revendication 13 est mis en mémoire.

**15.** Installation (1) de résonance magnétique comprenant un dispositif (8) de commande, **caractérisé en ce que** le dispositif (8) de commande est constitué pour effectuer un procédé suivant l'une des revendications 1 à 12.

FIG 1

FIG 2

FIG 3

FIG 4

FIG 5

FIG 6

$I_{max\_coil\_6}$

31

EP 3 564 695 B1

FIG 7

FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8879852 B2
- US 9784812 B2
- DE 102013213940 B3
- US 20160146915 A1
- US 9396562 B2
- US 8275294 B2

**In der Beschreibung aufgeführte Nicht-Patentliteratur**

- **HUANG F** ; **CHEN Y**. Self-adjusted regularization ratio for robust compressed sensing. *PROCEEDINGS OF THE INTERNATIONAL SOCIETY FOR MAGNETIC RESONANCE IN MEDICINE*, 18 April 2009, 4592
- **JAN AELTERMAN et al.** Automatic High-Bandwidth Calibration and Reconstruction of Arbitrarily Sampled Parallel MRI. *PLOS ONE*, 10 June 2014, vol. 9 (6), e98937
- **KEDAR KHARE et al.** Accelerated MR imaging using compressive sensing with no free parameters: Accelerated MR Imaging using Compressive Sensing. *MAGNETIC RESONANCE IN MEDICINE*, 20 January 2012, vol. 68 (5), ISSN 0740-3194, 1450-1457
- Reducing acquisition time in clinical MRI by data undersampling and compressed sensing reconstruction. **KIEREN GRANT HOLLINGSWORTH**. PHYSICS IN MEDICINE AND BIOLOGY. INSTITUTE OF PHYSICS PUBLISHING, 08 October 2015, vol. 60